# EUROPEAN PATENT APPLICATION

(11) **EP 4 404 699 A1**
(43) Date of publication of application: **24.07.2024**
(21) Application number: 22891923.9
(22) Date of filing: 07.11.2022
(51) Int. Cl.: H05K 7/14

(54) **COMMUNICATION DEVICE AND SERVICE SIGNAL SCHEDULING METHOD**

(30) Priority: 12.11.2021 CN 202111340276
(71) Applicant: Huawei Technologies Co., Ltd., Shenzhen, Guangdong 518129 (CN)
(72) Inventor: CHANG, Shifan, Shenzhen, Guangdong 518129 (CN)
(74) Representative: Körber, Martin Hans
(86) International application number: PCT/CN2022/130251
(87) International publication number: WO 2023/083129

(57) **Abstract**

This application discloses a communication device and a service signal scheduling method, and relates to the field of communication technologies. The communication device includes a cabinet (1), a plurality of subracks (2), and a plurality of switch boards (3). Each subrack includes a backplane (21) and a plurality of service boards (22), the backplane (21) is located in the subrack (2), the plurality of service boards (22) are pluggably installed in the subrack (2), and each service board (22) is electrically connected to the backplane (21). Each subrack (2) and each switch board (3) are pluggably installed in the cabinet (1), the backplane (21) of each subrack (2) is electrically connected to at least one of the switch boards (3), and each switch board (3) is electrically connected to at least one backplane (21). According to technical solutions of this application, during updating or repairing of a backplane (21), another backplane (21) is slightly affected or even not affected, and the communication device does not need to be stopped. This can improve use flexibility of the communication device and facilitates updating and repair of the backplane (21).

## Description

This application claims priority to Chinese Patent Application No. 202111340276.0, filed with the China National Intellectual Property Administration on November 12, 2021 and entitled "COMMUNICATION DEVICE AND SERVICE SIGNAL SCHEDULING METHOD", which is incorporated herein by reference in its entirety.

### TECHNICAL FIELD

This application relates to the field of communication technologies, and in particular, to a communication device and a service signal scheduling method.

### BACKGROUND

A communication device, such as a switch and a router, usually includes a cabinet, a backplane, a service processing board (which is briefly referred to as a service board or a line card), a switching network processing board (which is briefly referred to as a switch board or a network board), and the like. The backplane and the cabinet are fastened together, the cabinet includes a plurality of slots, and the service board and the switch board are both inserted into the slots and are electrically connected to the backplane. In this way, the service board may perform signal transmission with the switch board through the backplane, and service boards may perform mutual signal transmission through the backplane.

However, since the backplane and the cabinet are fastened together, communication of the communication device needs to be interrupted during upgrading or repair of the backplane. It can be learned that use flexibility of the communication device is poor, affecting upgrading and repair.

### SUMMARY

This application provides a communication device and a service signal scheduling method, to resolve a technical problem in a conventional technology that an entire communication device is stopped during upgrading or repair of a backplane.

According to a first aspect, an embodiment of this application provides a communication device. The communication device includes a cabinet, a plurality of subracks, and a plurality of switch boards. Each subrack includes a backplane and a plurality of service boards, the backplane is located in the subrack, the plurality of service boards are pluggably installed in the subrack, and each service board is electrically connected to the backplane. Each subrack and each switch board are pluggably installed in the cabinet, the backplane of each subrack is electrically connected to at least one of the switch boards, and each switch board is electrically connected to at least one backplane.

In the solution described in this application, the communication device includes the plurality of subracks, each subrack corresponds to one backplane, and each subrack can be inserted into the cabinet and also can be plugged out from the cabinet, so that each backplane can be flexibly removed from and installed in the cabinet through the subrack in which the backplane is located. It can be learned that, when some backplanes need to be updated or repaired, only the backplanes that need to be updated or repaired need to be stopped, another backplane is slightly affected or even not affected, and the entire communication device does not need to be stopped. This can improve use flexibility of the communication device.

In a possible implementation, the backplane of each subrack is electrically connected to any one of the switch boards.

In the solution described in this application, that the backplane of each subrack is electrically connected to any one of the switch boards may also be understood as that each backplane is electrically connected to all the switch boards. The backplane of each subrack is electrically connected to any one of the switch boards, in other words, each switch board is also electrically connected to any one of the backplanes. In this way, the service board in each subrack can be electrically connected to all the switch boards through a backplane in the same subrack, and each switch board can also be electrically connected to the service board in the subrack through the backplane in the subrack. This enables a service board in one subrack to perform service signal transmission with a service board in another subrack through the switch board.

In a possible implementation, backplanes of the plurality of subracks are arranged in a first direction, and the plurality of switch boards are arranged in a second direction. The first direction is perpendicular to the second direction.

In the solution described in this application, the first direction may be a longitudinal direction along a height direction of the cabinet, and the second direction may be a transverse direction along a length direction of the backplane. In this case, the backplanes of the plurality of subracks are arranged sequentially in the longitudinal direction, and the plurality of switch boards are arranged sequentially in the transverse direction. In this way, the backplane of each subrack can be orthogonal to any one of the switch boards, and each switch board can also be orthogonal to any one of the backplanes, so that each backplane can be directly electrically connected to any one of the switch boards, and each switch board can be directly electrically connected to any one of the backplanes.

In a possible implementation, the first direction is a direction perpendicular to a cabinet top panel of the cabinet, and the second direction is a direction perpendicular to a cabinet side panel of the cabinet. It should be understood that the first direction may also be understood as the height direction of the cabinet, and the second direction may also be understood as the length direction of the backplane.

In a possible implementation, each backplane is parallel to a cabinet panel of the cabinet, and each switch board is parallel to the cabinet side panel of the cabinet.

In the solution described in this application, each backplane may be vertically located in the subrack, and is parallel to the cabinet panel of the cabinet. Each switch board may also be vertically located in the cabinet, but is parallel to the cabinet side panel of the cabinet.

In a possible implementation, bandwidth capacities of a backplane and a service board that are located in a same subrack match each other.

In the solution described in this application, before a service board is inserted into a subrack, a subrack in which a matched backplane is located may be selected based on bandwidth capacities of all service boards to be inserted, and then the service boards are inserted into the selected subrack. In this way, the bandwidth capacities of the backplane and the service board that are located in the same subrack may match each other, so that the bandwidth capacity of the backplane can be fully used. This can alleviate bandwidth capacity surplus of the backplane, and reduce a waste of resources.

In a possible implementation, each service board is configured to: determine a destination service board when receiving a service signal; determine a relationship between the service board and the destination service board; and determine a destination port and output the service signal through the destination port if the service board and the destination service board belong to a same service board.

In the solution described in this application, each service board can perform intra-board service signal scheduling. For example, when the service signal is received, if it is determined that the destination service board is the board, the destination port may be further determined, and the service signal is output through the destination port. In the intra-board service signal scheduling, the service signal does not need to be transmitted to the backplane and the switch board. This can relieve processing pressure of the backplane and the switch board, and can also reduce a scheduling delay.

In a possible implementation, there are a plurality of destination ports, and each service board is configured to: replicate the service signal based on a quantity of destination ports to obtain a plurality of service signals, and output each service signal through one destination port.

In the solution described in this application, if the service signal is a multicast service signal, destination ports corresponding to multicast service signals are different. In this case, the service signal may be replicated based on the quantity of destination ports to obtain the plurality of service signals, and the service signals are respectively output through different destination ports.

In a possible implementation, any two service boards in each subrack are electrically connected, and each service board is configured to: determine a destination service board when receiving a service signal; determine a relationship between the service board and the destination service board; and send the service signal to the destination service board if the service board and the destination service board belong to different service boards but a same subrack. Any two service boards in a same subrack are electrically connected. Therefore, whether service boards belong to a same subrack may be determined depending on whether the service boards are electrically connected.

In the solution described in this application, the communication device may perform intra-subrack inter-board service signal scheduling. After receiving the service signal, the service board determines that the service board and the destination service board do not belong to the same service board, but belong to the same subrack. In this case, the service board that receives the service signal may send the service signal to the destination service board. In the intra-subrack inter-board service signal scheduling, the service signal does not need to be transmitted to the switch board. This can relieve processing pressure of the switch board, and can also reduce a scheduling delay.

In a possible implementation, there are a plurality of destination service boards, and each service board is configured to: replicate the service signal based on a quantity of the destination service boards to obtain a plurality of service signals, and send the service signal to each destination service board.

In the solution described in this application, if the service signal is a multicast service signal, destination service boards corresponding to the multicast service signal are different. In this case, the service signal may be replicated based on the quantity of the destination service boards to obtain the plurality of service signals, and the service signals are respectively sent to the destination service boards.

For example, if the quantity of destination service boards is n, the service board may replicate the received service signal to obtain n service signals, and then respectively send the n service signals to the n destination service boards, where n is an integer greater than 1.

In a possible implementation, each service board is configured to: determine a destination service board when receiving a service signal; determine a relationship between the service board and the destination service board; and send the service signal to the switch board if the service board and the destination service board belong to different service boards and different subracks, so that the switch board sends the service signal to the destination service board.

In the solution described in this application, the communication device can not only perform the intra-board service signal scheduling, but also perform the intra-subrack inter-board service signal scheduling, and still perform service signal scheduling through the switch board. For example, after receiving the service signal, the service board determines that the service board and the destination service board do not belong to the same service board and are not electrically connected. In other words, the service board that receives the service signal and the destination service board do not belong to the same subrack. In this case, the service board that receives the service signal may send the service signal to the switch board through the backplane. After receiving the service signal, the switch board first determines the destination service board, and then sends the service signal to the destination service board through a backplane of a subrack in which the destination service board is located.

In a possible implementation, the destination service board is determined based on the service board that receives the service signal and a pre-stored service board correspondence. The destination port is determined based on a port that receives the service signal and a pre-stored port correspondence.

In the solution described in this application, the destination service board may be determined based on the preconfigured service board correspondence. The service board correspondence is a correspondence between slot numbers of slots in which the service boards are located. Similarly, the destination port may also be determined based on the port that receives the service signal and the preconfigured port correspondence.

In a possible implementation, both the destination service board and the destination port of the destination service board are determined based on a destination address carried in the service signal.

In the solution described in this application, both the destination service board and the destination port may alternatively be determined based on the destination address carried in the service signal. A manner in which the destination service board and the destination port are determined is not limited in this application, and may be flexibly selected based on an actual situation.

According to a second aspect, an embodiment of this application provides a service signal scheduling method, where the method is applied to a communication device. The communication device may be a communication device that includes a subrack, or may be a communication device that does not include a subrack, and this is not limited in this application. A specific execution body of the method may be a control board of the communication device, or may be a service board of the communication device, and this is not limited in this application.

The method includes: determining a destination service board when receiving a service signal; determining a relationship between a service board that receives the service signal and the destination service board; and outputting the service signal based on the relationship between the service board that receives the service signal and the destination service board.

In the solution described in this application, when receiving the service signal, the service board may determine the destination service board, for example, based on a preconfigured service board correspondence, or based on a destination address carried in the service signal. After determining the destination service board, the service board that receives the service signal determines the relationship between the service board and the destination service board, for example, determines whether the service board and the destination service board belong to the same service board, and whether the service board and the destination service board are electrically connected. Then, an output of the service signal is controlled based on the relationship between the service board that receives the service signal and the destination service board.

In a possible implementation, the determining a relationship between a service board that receives the service signal and the destination service board includes: determining that the service board that receives the service signal and the destination service board belong to a same service board; and the outputting the service signal includes: determining a destination port based on the destination service board, and outputting the service signal through the destination port.

In the solution described in this application, the service board that receives the service signal determines that the service board and the destination service board belong to the same service board, in other words, determines that the destination service board is the board. Then, the destination port is further determined, and the service signal is output through the destination port. In intra-board service signal scheduling, the service signal does not need to be transmitted to a backplane, and does not need to be transmitted to a switch board. This can reduce a delay, and relieve pressure of the backplane and the switch board.

In a possible implementation, the determining a relationship between a service board that receives the service signal and the destination service board includes: determining that the service board that receives the service signal and the destination service board belong to different service boards and are electrically connected; and the outputting the service signal includes: sending the service signal to the destination service board through the service board that receives the service signal; and determining a destination port based on the destination service board, and outputting the service signal through the destination port.

In the solution described in this application, the service board that receives the service signal determines that the service board and the destination service board belong to different service boards but are electrically connected. In this case, the service board that receives the service signal may send the service signal to the destination service board. After receiving the service signal, the destination service board determines that a destination service board is the board, further determines the destination port, and outputs the service signal through the destination port. In inter-board service signal scheduling, the service signal needs to be transmitted only to a backplane, and does not need to be transmitted to a switch board. This can reduce a delay, and relieve pressure of the switch board.

In a possible implementation, the determining a relationship between a service board that receives the service signal and the destination service board includes: determining that the service board that receives the service signal and the destination service board belong to different service boards and are not electrically connected; and the outputting the service signal includes: sending the service signal to a switch board through the service board that receives the service signal; sending the service signal to the destination service board through the switch board; and determining a destination port based on the destination service board, and outputting the service signal through the destination port.

In the solution described in this application, the service board that receives the service signal determines that the service board and the destination service board belong to different service boards, and are not electrically connected. In this case, the service board that receives the service signal sends the service signal to the switch board through a backplane. After receiving the service signal, the switch board determines the destination service board, and transmits the service signal to the destination service board through the backplane. After receiving the service signal, the destination service board determines that a destination service board is the board, further determines the destination port, and outputs the service signal through the destination port.

In the solution described in this application, when the service signal is scheduled by using the method, after the destination service board is determined, the relationship between the service board that receives the service signal and the destination service board is determined, and the output of the service signal is controlled based on the relationship between the service board that receives the service signal and the destination service board. For example, if it is determined that the service board that receives the service signal and the destination service board belong to the same service board, or are electrically connected, the switch board may not be required during service signal scheduling. This can relieve processing pressure of the switch board, and can also reduce a service signal scheduling delay.

According to a third aspect, this application provides a communication device. T the device includes a processor and a memory, the memory stores at least one computer instruction, and the computer instruction is loaded and executed by the processor to implement the service signal scheduling method provided in any one of the second aspect or the optional manners of the second aspect.

### BRIEF DESCRIPTION OF DRAWINGS

FIG. 1 is a schematic exploded diagram of a communication device according to this application;
FIG. 2 is a schematic diagram of a position relationship between a subrack and a switch board of a communication device according to this application;
FIG. 3 is a schematic diagram of service signal transmission of a communication device according to this application;
FIG. 4 is a schematic diagram of service signal transmission of a communication device according to this application;
FIG. 5 is a schematic diagram of service signal transmission of a communication device according to this application;
FIG. 6 is a schematic flowchart of service signal scheduling of a communication device according to this application;
FIG. 7 is a schematic diagram of a position relationship between a backplane, a service board, and a switch board of a communication device according to this application;
FIG. 8 is a schematic flowchart of service signal scheduling of a communication device according to this application; and
FIG. 9 is a schematic structural diagram of a communication device according to this application.

### Reference numerals:

1: Cabinet; 11: Cabinet top panel; 12: Cabinet side panel; 13: Cabinet panel; 2: Subrack; 21: Backplane; 22: Service board; and 3: Switch board. 900: Device; 901: Processor; 902: Communication bus; 903: Memory; 904: Network interface; and 9031: Program code.

### DESCRIPTION OF EMBODIMENTS

Embodiments of this application provide a communication device. The communication device may be a device such as a switch and a router. The communication device may be a cabinet device. The cabinet device may also be referred to as a device in which boards and modules are mountable, and usually includes a cabinet, a backplane, a service processing board, and a switching network processing board.

The service processing board may be briefly referred to as a service board or a line card, and is mainly responsible for receiving and sending a signal, processing a signal, and the like. The switching network processing board may be briefly referred to as a switch board or a network board, and is mainly responsible for forwarding a signal between service boards. The backplane is mainly responsible for providing a physical connection for signal transmission between the service board and the switch board.

Usually, the backplane is fastened to the rear of the cabinet, both the service board and the switch board are pluggably installed in the cabinet, and the service board and the backplane are electrically connected, for example, electrically connected through a connector. The switch board and the backplane are electrically connected, for example, electrically connected through a connector. In this way, after receiving a service signal, the service board may send the service signal to the switch board through the backplane, and the switch board forwards the service signal to another service board through the backplane, to complete service signal scheduling.

However, in application, it is found that at least the following problems exist in the foregoing communication device. First, because the backplane and the cabinet are fastened together, the communication device needs to be stopped from operating when the backplane needs to be updated or maintained and repaired. This does not facilitate updating and repair of the backplane and causes poor use flexibility of the communication device. Second, bandwidth capacities of the service board and the backplane of a communication device do not match. For example, a bandwidth capacity of the backplane is far greater than a bandwidth capacity of the service board. Consequently, the bandwidth capacity of the backplane cannot be fully used, resulting in resource surplus.

For example, before the cabinet is processed, a maximum bandwidth capacity of the communication device may be predicted based on a quantity of service boards that can be inserted in the cabinet and a maximum bandwidth capacity of each service board. A backplane that matches the maximum bandwidth capacity of the communication device is then selected as the backplane of the communication device. However, after processing on the communication device is completed, in actual application, the communication device is not necessarily fully inserted with service boards, and the bandwidth capacity of the service board inserted into the communication device is not necessarily the maximum bandwidth capacity. Consequently, the bandwidth capacity of the backplane of the communication device is far greater than the bandwidth capacity of the service board, resulting in excess of the bandwidth capacity of the backplane and resource surplus.

In addition, after receiving the service signal, the service board needs to transmit the service signal to the switch board through the backplane, and the switch board performs service signal scheduling. This causes great pressure on the switch board. In addition, no matter the service signal is scheduled from one service board to another service board, or is scheduled from one port to another port on a same service board, the service signal scheduling needs to be performed through the switch board. The service signal needs to pass from the service board to the backplane and then to the switch board, and from the switch board to the backplane and then to the service board. This causes a long delay of the service signal.

In the communication device provided in this solution, the entire communication device does not need to be stopped during upgrading or repair of the backplane. The backplane may be pluggably installed in the cabinet. Therefore, when the service board is installed, a proper backplane may be selected based on a quantity of service boards to be inserted and a bandwidth capacity of each service board, so that the bandwidth capacity of the service board matches the bandwidth capacity of the backplane. This can alleviate bandwidth capacity surplus of the backplane.

In addition, in the communication device provided in this solution, each service board can perform intra-board service signal scheduling, and can also perform inter-board service signal scheduling between different service boards. In the two types of service signal scheduling, the service signal does not need to be transmitted to the backplane or the switch board. This can relieve pressure of the switch board, and reduce a scheduling delay.

The following first describes structural features of the communication device, and then describes a service signal scheduling process of the communication device.

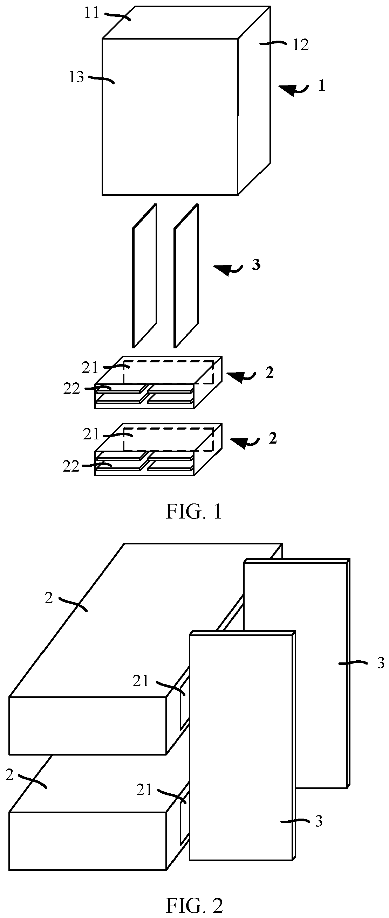

As shown in FIG. 1, the communication device includes a cabinet 1, subracks 2, and switch boards 3. There are a plurality of subracks 2 and a plurality of switch boards 3. A quantity of subracks 2 may be equal to or different from a quantity of switch boards 3. The subrack 2 may be of a flat open box structure, including a subrack top panel, a subrack bottom panel, a subrack side panel, and a subrack backplane. A position of an opening of the subrack 2 is opposite to a position of the subrack backplane, and the opening of the subrack 2 is provided for insertion and removal of a service board 22. Each subrack 2 includes a backplane 21. The backplane 21 may be the subrack backplane of the subrack 2, or the backplane 21 is fastened to the subrack backplane, and the backplane 21 may be integrated with the subrack 2.

Each backplane 21 may be a printed circuit board (printed circuit board, PCB) backplane, or may be a cable (cable) backplane, or may be an optical fiber backplane. For example, backplanes 21 of all the subracks 2 of the communication device are one of the foregoing three types of backplanes, for example, all being PCB backplanes, all being cable backplanes, or all being optical fiber backplanes. For another example, the backplanes 21 of the plurality of subracks 2 of the communication device are a combination of several of the foregoing three types of backplanes. For example, some are PCB backplanes, and others are cable backplanes. Alternatively, some are PCB backplanes, and others are optical fiber backplanes. Alternatively, some are cable backplanes, and others are optical fiber backplanes. For another example, some are PCB backplanes, some are cable backplanes, and others are optical fiber backplanes. A specific type of the backplane 21 is not limited in embodiments, and may be flexibly selected based on an actual requirement.

It should be noted that, if the backplane 21 is a PCB backplane or a cable backplane, a connection relationship between the backplane 21 and the service board 22 and a connection relationship between the backplane 21 and the switch board 3 are both electrical connection relationships. However, if the backplane 21 is an optical fiber backplane, the connection relationship between the backplane 21 and the service board 22 and the connection relationship between the backplane 21 and the switch board 3 are both optical fiber interconnection. In this solution, for ease of description, an electrical connection is used to describe the connection relationship between the backplane 21 and the service board 22 and the connection relationship between the backplane 21 and the switch board 3.

Each subrack 2 further includes a plurality of service boards 22 that are pluggably installed in the subrack 2. For example, the service board 22 may be inserted into the subrack 2 at the opening of the subrack 2 for installation into the subrack 2. The service board 22 may also be plugged out from the opening of the subrack 2 for removal from the subrack 2.

In an example, after being inserted into the subrack 2, the service board 22 is electrically connected to a backplane 21 in the same subrack 2. For example, a connector is provided at an inner surface that is of the backplane 21 and that is in the subrack 2, and a connector is provided at a position that is of the service board 22 and that is near the backplane 21. The backplane 21 and the service board 22 in the same subrack 2 may be electrically connected through the connectors. A plurality of ports may be provided in a panel that is of each service board 22 and that is away from the backplane 21, and the ports are configured to transmit a signal to the service board 22 and output a signal from the service board 22.

The foregoing describes the structural features of the subrack 2, and the following describes structural features of the cabinet 1.

As shown in FIG. 1, the cabinet 1 may be in a cuboid shape, including a cabinet top panel 11, a cabinet side panel 12, a cabinet panel 13, a cabinet backplane, and a cabinet bottom panel. The cabinet bottom panel is located on the ground, the cabinet top panel 11 and the cabinet bottom panel are opposite, two cabinet side panels 12 are opposite, and the cabinet panel 13 and the cabinet backplane are opposite. Space enclosed by the cabinet top panel 11, the two cabinet side panels 12, the cabinet panel 13, the cabinet backplane, and the cabinet bottom panel is provided for accommodation of the subrack 2 and the switch board 3. In addition, components such as a power supply component and a heat dissipation component are further installed in the cabinet 1, to ensure that the communication device can work normally.

In an example, each subrack 2 is pluggably installed in the cabinet 1. For example, a slot is provided on the cabinet panel of the cabinet 1, and the subrack 2 may be inserted into the slot of the cabinet 1 for installation in the cabinet 1; or may be plugged out from the slot of the cabinet 1 for removal from the cabinet 1. Similarly, the switch board 3 may also be pluggably installed in the cabinet 1.

For an assembly sequence of the communication device, a subrack 2 in which no service board 22 is inserted may be first inserted into the cabinet 1, and a service board 22 is then inserted into each subrack 2. Alternatively, a service board 22 may be first inserted into each subrack 2, and each subrack 2 inserted with the service board 22 is then inserted into the cabinet 1. An insertion sequence of service boards 22, an insertion sequence of subracks 2, and an insertion sequence of switch boards 3 are not limited in embodiments. Insertion may be performed in any sequence or synchronously performed, or may be flexibly selected based on an actual requirement.

After the subrack 2 is inserted into the cabinet 1, the backplane 21 in each subrack 2 is electrically connected to at least one of the switch boards 3. For example, each backplane 21 may be electrically connected to some switch boards 3, and is not electrically connected to other switch boards 3. For another example, each backplane 21 may be electrically connected to any switch board 3. That each backplane 21 is electrically connected to any switch board 3 may also be understood as that each backplane 21 is electrically connected to all the switch boards 3.

After the switch board 3 is inserted into the cabinet 1, each switch board 3 is electrically connected to the backplane 21 in at least one of the subracks 2. For example, each switch board 3 may be electrically connected to backplanes 21 of some subracks 2, and are not electrically connected to backplanes 21 of other subracks 2. For another example, each switch board 3 may be electrically connected to the backplane 21 of any one of the subracks 2. That each switch board 3 is electrically connected to the backplane 21 of any one of the subracks 2 may also be understood as that each switch board 3 is electrically connected to the backplanes 21 of all the subracks 2.

In an example, an electrical connection manner between the backplane 21 and the switch board 3 may be implemented through a connector. For example, a connector is provided at a position that is of the backplane 21 and that is close to the switch board 3, and a connector is provided at a location that is of the switch board 3 and that is close to the backplane 21. The connectors of the switch board 3 and the backplane 21 may be connected to implement an electrical connection. Specifically, which switch boards 3 are electrically connected to each backplane 21, which backplanes 21 are electrically connected to each switch board 3, and an implementation of the electrical connection are not limited in embodiments and may be selected based on an actual requirement.

In an example, to facilitate that the backplane 21 of each subrack 2 can be electrically connected to any switch board 3, and that each switch board 3 can be electrically connected to the backplane 21 of any subrack 2, correspondingly, the backplanes 21 of the plurality of subracks 2 may be arranged in a first direction, and the plurality of switch boards 3 may be arranged in a second direction, as shown in FIG. 2. The first direction and the second direction are perpendicular to each other. For example, in FIG. 2, a plurality of subracks 2 are arranged in a longitudinal direction, and a plurality of switch boards 3 are arranged in a transverse direction. In this way, the backplane 21 of each subrack 2 can intersect with all the switch boards 3, and each switch board 3 can intersect with the backplanes 21 of all the subracks 2, so that each backplane can be directly electrically connected to all the switch boards.

In an example, the first direction may be a direction perpendicular to the cabinet top panel 11 of the cabinet 1, and the second direction may be a direction perpendicular to the cabinet side panel 12 of the cabinet 1. Alternatively, the first direction is a direction perpendicular to the cabinet side panel 12 of the cabinet 1, and the second direction is a direction perpendicular to the cabinet top panel 11 of the cabinet 1. A specific direction of the first direction and the second direction is not limited in embodiments, provided that the first direction and the second direction are perpendicular to each other.

For example, as shown in FIG. 2 and with reference to FIG. 1, the backplanes 21 of the plurality of subracks 2 may be vertically arranged, and each backplane 21 is parallel to the cabinet panel 13 of the cabinet 1. The plurality of switch boards 3 may be arranged in a transverse direction, and each switch board 3 is parallel to the cabinet side panel 12 of the cabinet 1. As shown in FIG. 2, in the arrangement manner of the plurality of backplanes 21 and the plurality of switch boards 3, it can be implemented that each backplane 21 is orthogonal to any switch board 3, and each switch board 3 is orthogonal to any backplane 21, so that each backplane 21 can be directly electrically connected to any one of the switch boards 3.

It can be learned from the foregoing description that, because the cabinet 1 includes the plurality of backplanes 21, each backplane 21 can be pluggably installed in the cabinet 1 through the subrack 2 in which the backplane 21 is located. Therefore, when one of the backplanes 21 needs to be replaced, it only needs to plug out, from the cabinet 1, a subrack 2 in which the backplane 21 is located. A backplane 21 in another subrack 2 is not affected, and the entire communication device does not need to be stopped from working. Therefore, when a specific backplane 21 or some backplanes 21 is/are updated or repaired, only the backplane 21 that needs to be updated or repaired needs to be stopped, and another backplane 21 is slightly affected or even not affected. This can improve use flexibility of the communication device, and facilitates an update and repair of the backplane 21 later.

In an example, to fully use a bandwidth capacity of each backplane 21, correspondingly, bandwidth capacities of a backplane 21 and a service board 22 located in a same subrack 2 may match each other. For example, before a service board 22 is inserted into a subrack 2, a subrack 2 in which a matched backplane 21 is located may be selected based on bandwidth capacities of all service boards 22 to be inserted, and then the service boards 22 are inserted into the selected subrack 2. In this way, bandwidth capacities of the backplane 21 and all the inserted service boards 22 that are located in the same subrack 2 may match each other, so that the bandwidth capacity of the backplane 21 can be fully used. This can alleviate bandwidth capacity surplus of the backplane 21, and reduce a waste of resources. That bandwidth capacities of the backplane 21 and all the inserted service boards 22 that are located in the same subrack 2 may match each other may be that for the subrack 2, the bandwidth capacity of the backplane 21 is equal to or slightly greater than a sum of the bandwidth capacities of all the service boards 22 in the subrack 2.

In addition, running speeds of the backplane 21 and the service board 22 that are located in the same subrack 2 may also match each other. In this way, a service board 22 with a low running speed may be inserted into a subrack 2 in which a backplane 21 with a low running speed is located. A service board 22 with a high running speed may be inserted into a subrack 2 in which a backplane 21 with a high running speed is located. This can fully use a running capability of the backplane 21, and reduce a waste of resources.

The foregoing describes the structural features of the communication device, and the following describes the service signal scheduling process of the communication device.

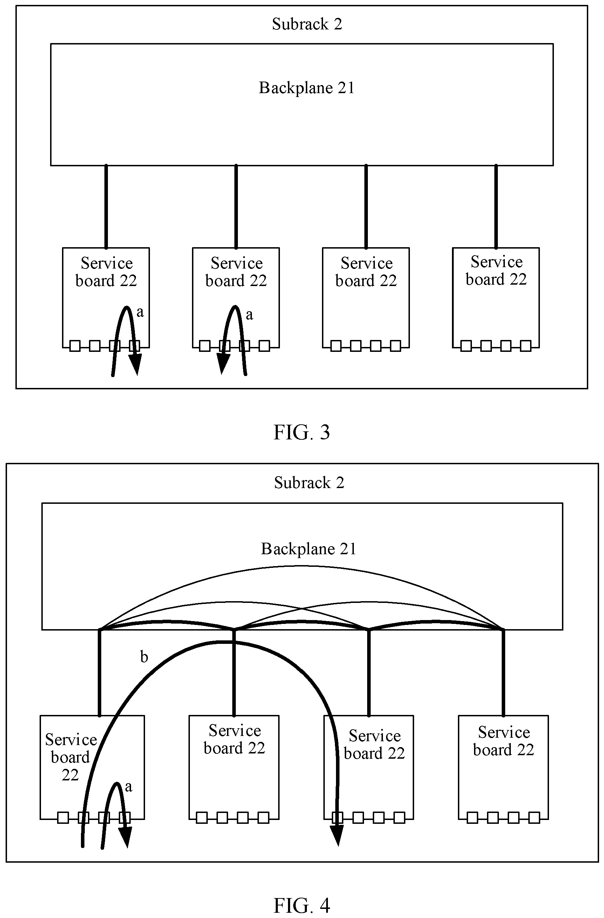

Each service board 22 may perform intra-board service signal scheduling. For example, the service board 22 may determine a destination service board when receiving a service signal; determine a relationship between the service board 22 and the destination service board; and further determine a destination port and then output the received service signal through the destination port if the service board 22 and the destination service board belong to a same service board. For a service signal transmission process, refer to FIG. 3. A curve a with an arrow in FIG. 3 shows intra-board transmission of a service signal. In the solution of intra-board service signal scheduling, the service signal does not need to be transmitted to the backplane, and does not need to be transmitted to the switch board, either. This can relieve pressure of the backplane and the switch board, and reduce a service signal scheduling delay.

Intra-subrack inter-board service signal scheduling may be performed between service boards 22 in a same subrack 2. To implement the intra-subrack inter-board service signal scheduling, correspondingly, any two service boards 22 in a same subrack 2 are electrically connected. Therefore, whether two service boards 22 belong to a same subrack may be determined by determining whether the two service boards are electrically connected. For example, if two service boards 22 are electrically connected, the two service boards 22 belong to a same subrack 2. However, if two service boards 22 are not electrically connected, the two service boards 22 do not belong to a same subrack 2.

In this way, when the service board 22 receives a service signal, the service board 22 first determines a destination service board, and then determines a relationship between the service board 22 and the destination service board. If the service board 22 and the destination service board belong to different service boards but belong to a same subrack 2, in other words, the service board 22 that receives the service signal and the destination service board belong to different service boards, but are electrically connected, the service board 22 that receives the service signal may send the service signal to the destination service board 22. After receiving the service signal, the destination service board 22 also determines a relationship between a destination service board to which the service signal is to flow and the destination service board, and then determines that the destination service board to which the service signal is to flow is the destination service board, and further determines a destination port, and outputs the service signal through the destination port. For a service signal transmission process, refer to FIG. 4. A curve b with an arrow in FIG. 4 shows transmission of a service signal between two service boards 22 in a same subrack 2.

In the solution of intra-subrack inter-board service signal scheduling, the service signal needs to be transmitted to another service board 22 in the same subrack 2 only through the backplane 21, without a need of using the switch board 3. This can relieve pressure of the switch board 3, and reduce a service signal scheduling delay.

Inter-subrack service signal scheduling may be performed, through the switch board 3, between service boards 22 that belong to different subracks 2. To implement the inter-subrack service signal scheduling, correspondingly, the backplane 21 in each subrack 2 is electrically connected to at least one of the switch boards 3, so that the service board 22 in each subrack 2 can be indirectly electrically connected to the switch board 3 through the backplane 21, the service board 22 can transmit the service signal to the switch board 3 through the backplane 21, and the switch board 3 can also transmit the service signal to the service board 22 through the backplane 21.

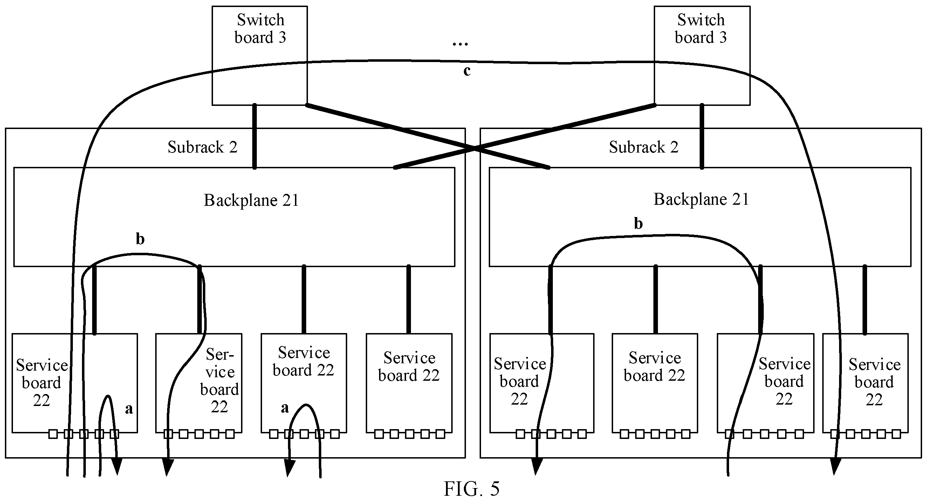

In this way, when the service board 22 receives the service signal, the service board 22 first determines a destination service board, and then determines a relationship between the service board 22 and the destination service board. If the service board 22 and the destination service board belong to different service boards and do not belong to a same subrack 2, in other words, the service board 22 that receives the service signal and the destination service board belong to different service boards, and are not electrically connected, the service board 22 that receives the service signal may send the service signal to the switch board 3 through the backplane 21 in the same subrack 2. After receiving the service signal, the switch board 3 first determines the destination service board 22, and then sends the service signal to the destination service board through a backplane 21 of a subrack 2 in which the destination service board is located. After receiving the service signal, the destination service board 22 determines that a service board to which the service signal is to be sent in the next step is the board, and further determines a destination port, and outputs the service signal through the destination port. For a service signal transmission process, refer to FIG. 5. A curve c with an arrow in FIG. 5 shows transmission of a service signal between two service boards 22 in different subracks 2.

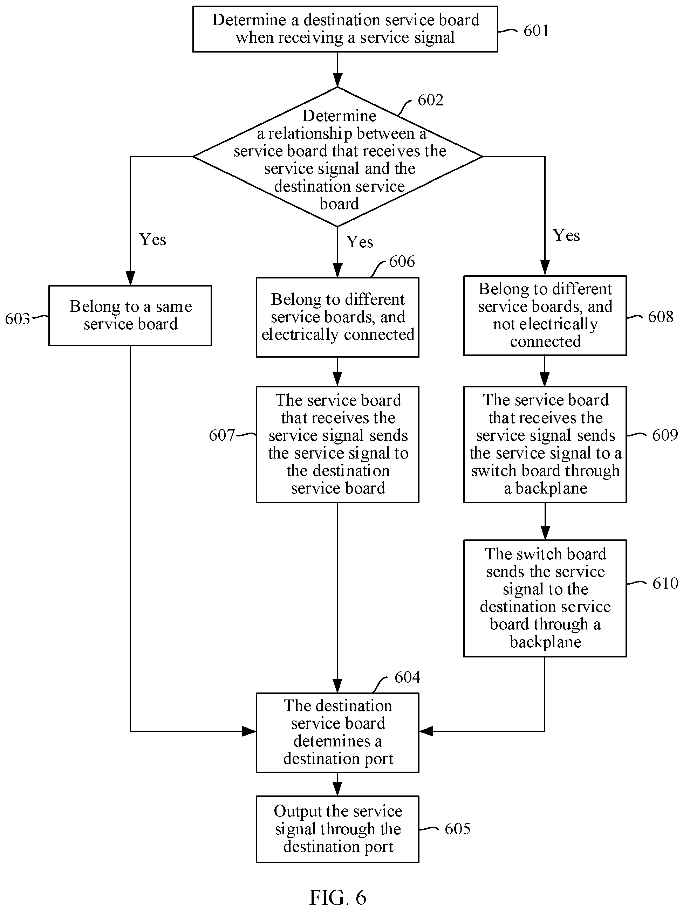

It can be learned from the foregoing description that the communication device may schedule the service signal according to a procedure shown in FIG. 6.

The procedure shown in FIG. 6 may be performed by a control board of the communication device, for example, in a scenario of a time division multiplexing (time division multiplexing, TDM) service. Alternatively, the procedure may be performed by a service board, for example, in a scenario of a packet service. An execution body of service signal scheduling is not limited in this embodiment, and the service board may be used as an example for description.

In step 601, a destination service board may be determined when a service signal is received.

In an example, a manner of determining the destination service board may be: determining, based on a pre-stored service board correspondence, the destination service board corresponding to the service board that receives the service signal. Another manner of determining the destination service board may be that the received service signal carries a destination address, and the destination service board may be determined based on the carried destination address.

In step 602, a relationship between the service board that receives the service signal and the destination service board is determined.

In step 603, it is determined that the service board that receives the service signal and the destination service board belong to a same service board. In this case, step 604 is performed after step 603.

In step 604, the destination service board determines a destination port.

In an example, a manner of determining the destination port may be: determining, based on a pre-stored port correspondence, the destination port corresponding to a port that receives the service signal. Another manner of determining the destination port may be that the received service signal carries a destination address, and the destination port may be determined based on the carried destination address.

In step 605, the service signal is output through the destination port.

The foregoing is an execution process of steps 601 to 605. Step 606 instead of step 603 may be performed after step 602.

In step 606, it is determined that the service board that receives the service signal and the destination service board belong to different service boards, and are electrically connected. In this case, step 607 is performed after step 606.

In step 607, the service board that receives the service signal sends the service signal to the destination service board.

For example, the service board that receives the service signal sends the service signal to the destination service board through a backplane 21 in a same subrack 2. Steps 604 and 605 are sequentially performed after step 607.

The foregoing is an execution process of steps 601 and 602, steps 606 and 607, and steps 604 and 605. Step 608 instead of steps 603 and 606 may be performed after step 602.

In step 608, it is determined that the service board that receives the service signal and the destination service board belong to different service boards, and are not electrically connected. In this case, step 609 is performed after step 608.

In step 609, the service board 22 that receives the service signal sends the service signal to a switch board 3 through a backplane 21. Step 610 is performed after step 609.

In step 610, the switch board 3 sends the service signal to the destination service board through the backplane 21. Steps 604 and 605 are sequentially performed after step 610.

It can be learned from the foregoing description that, after receiving the service signal, the communication device may complete scheduling according to one of three branches shown in FIG. 6. One branch is steps 601 to 605; another branch is steps 601 and 602, steps 606 and 607, and steps 604 and 605; and still another branch is steps 601 and 602, steps 608 to 610, and steps 604 and 605.

When the communication device performs service signal scheduling according to the procedure shown in FIG. 6, because intra-board service signal scheduling may be performed, or intra-subrack inter-board service signal scheduling may be performed, and the switch board 3 does not need to be used in the two manners. This can relieve pressure of the switch board 3, and reduce a delay.

In an example, the service signal may be a unicast service signal, or may be a multicast service signal. For multicast service signals, if destination service boards corresponding to the multicast service signals are different, a plurality of destination service boards may be determined in step 601. In this case, the service board that receives the service signal may replicate the service signal based on a quantity of destination service boards, to obtain a plurality of service signals. Then, the plurality of service signals may be respectively sent to the destination service boards in step 607. Alternatively, the plurality of service signals may alternatively be respectively sent to switch boards 3 in step 609.

In another example, for multicast service signals, if destination ports corresponding to the multicast service signals are different, a plurality of destination ports may be determined in step 604. In this case, the destination service board that receives the service signal may replicate the service signal based on a quantity of destination ports to obtain a plurality of service signals, and output each service signal through one destination port.

It can be learned from the foregoing description that the communication device includes a plurality of subracks, each subrack corresponds to one backplane, and each subrack can be inserted into a cabinet, and can be plugged out from the cabinet, so that each backplane can be flexibly removed and installed in the cabinet through the subrack in which the backplane is located. It can be learned that, when some backplanes need to be updated or repaired, only the backplanes that need to be updated or repaired need to be stopped, another backplane is slightly affected or even not affected, and the entire communication device does not need to be stopped. This can improve use flexibility of the communication device and facilitate an update and repair of the backplane.

Bandwidth capacities of a backplane and an inserted service board that are in a same subrack of the communication device match each other, so that the bandwidth capacity of each backplane can be fully used. This reduces bandwidth capacity surplus of the backplane, and reduces a waste of resources.

After the communication device receives the service signal, if the destination service board and the service board that receives the service signal belong to the same service board, the service signal may be directly scheduled in the board, in other words, the service signal is input from one port of the board and output from another port of the board, and the service signal does not need to be transmitted to the backplane and the switch board. This can relieve pressure of the backplane and the switch board, and reduce a service signal scheduling delay. When the destination service board and the service board that receives the service signal are electrically connected, the service signal may be directly scheduled between boards, and is transmitted from one service board to another service board through the backplane, without a need of being transmitted to the switch board. This can also relieve processing pressure of the switch board, and reduce a service signal scheduling delay.

In the solution described in this application, the communication device includes the plurality of subracks, each subrack corresponds to one backplane, and each subrack can be inserted into the cabinet and can be plugged out from the cabinet, so that each backplane can be flexibly removed from and installed in the cabinet through the subrack in which the backplane is located. It can be learned that, when some backplanes need to be updated or repaired, only the backplanes that need to be updated or repaired need to be stopped, another backplane is slightly affected or even not affected, and the entire communication device does not need to be stopped. This can improve use flexibility of the communication device and facilitate an update and repair of the backplane.

An embodiment of this application further provides a service signal scheduling method. The method may be applied to a communication device, and may be specifically performed by a control board of the communication device, or may be performed by a service board of the communication device. The communication device to which the method is applied may be the communication device that includes the subrack 2 described above, or may be a communication device that does not include the subrack 2.

For example, the communication device to which the method is applied may include a cabinet 1, a plurality of subracks 2, and a plurality of switch boards 3, and the subrack 2 includes a backplane 21 and a plurality of service boards 22. The subrack 2 and the switch board 3 are pluggably installed in the cabinet 1, the backplane 21 is installed on the rear of each subrack 2, and the service board 22 is pluggably installed in the subrack 2, as shown in FIG. 1.

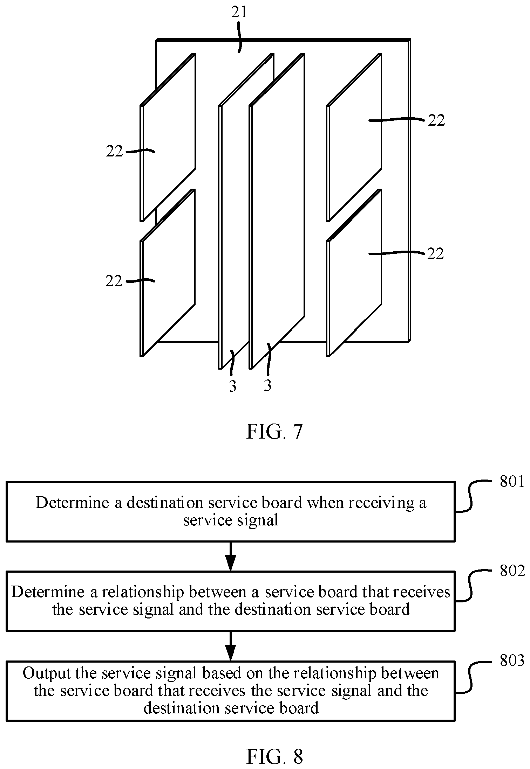

For another example, the communication device to which the method is applied may include a cabinet 1, a backplane 21, a plurality of service boards 22, and a plurality of switch boards 3. The backplane 21 is installed on the rear of the cabinet 1, and the plurality of service boards 22 and the plurality of switch boards 3 are all pluggably installed in the cabinet 1, as shown in FIG. 7. A specific structure of the communication device to which the method is applied is not limited in this embodiment.

FIG. 8 is a schematic flowchart of the method.

In step 801, a destination service board is determined when a service signal is received.

For example, when a specific service board receives the service signal, the destination service board may be determined based on a pre-stored service board correspondence. For another example, when a specific service board receives the service signal, the destination service board may be determined based on a destination address carried in the service signal. A manner of determining the destination service board is not specifically limited in this embodiment, provided that the destination service board can be determined.

In step 802, a relationship between the service board that receives the service signal and the destination service board is determined.

In an example, after determining the destination service board, the service board that receives the service signal may determine the relationship between the service board and the destination service board. For example, the relationship between the service board that receives the service signal and the destination service board includes: the service board that receives the service signal and the destination service board belong to a same service board, the service board that receives the service signal and the destination service board belong to different service boards but are electrically connected, and the service board that receives the service signal and the destination service board do not belong to a same service board and are not electrically connected.

In step 803, the service signal is output based on the relationship between the service board that receives the service signal and the destination service board.

In an example, after determining the relationship between the service board that receives the service signal and the destination service board, the service board that receives the service signal may output the received service signal based on the relationship between the service board that receives the service signal and the destination service board.

For example, if it is determined that the service board that receives the service signal and the destination service board belong to the same service board, in other words, it is determined that the service board that receives the service signal is the destination service board, the destination service board may further determine a destination port, and output the service signal through the destination port.

For another example, if it is determined that the service board that receives the service signal and the destination service board do not belong to the same service board, but are electrically connected, the service board that receives the service signal may send the service signal to the destination service board. After receiving the service signal, the destination service board also determines a relationship between the destination service board and a destination service board to which the service signal is to flow, determines that the service board to which the service signal is to flow is the board, further determines a destination port, and outputs the service signal through the destination port.

For another example, if it is determined that the service board that receives the service signal and the destination service board do not belong to the same service board, and are not electrically connected, the service board that receives the service signal may send the service signal to the switch board through the backplane. After receiving the service signal, the switch board determines the destination service board, and then may send the service signal to the destination service board through the backplane. After receiving the service signal, the destination service board also determines a relationship between the destination service board and a destination service board to which the service signal is to flow, determines that the service board to which the service signal is to flow is the board, further determines a destination port, and outputs the service signal through the destination port.

When the communication device schedules the service signal by using the method, the method may be performed according to the procedure shown in FIG. 6. For a specific process, refer to the foregoing description. Details are not described herein again.

In the solution described in this application, when the service signal is scheduled by using the method, after the destination service board is determined, the relationship between the service board that receives the service signal and the destination service board is determined, and the output of the service signal is controlled based on the relationship between the service board that receives the service signal and the destination service board. For example, if it is determined that the service board that receives the service signal and the destination service board belong to the same service board, or are electrically connected, the switch board may not be required during service signal scheduling. This can relieve processing pressure of the switch board, and can also reduce a service signal scheduling delay.

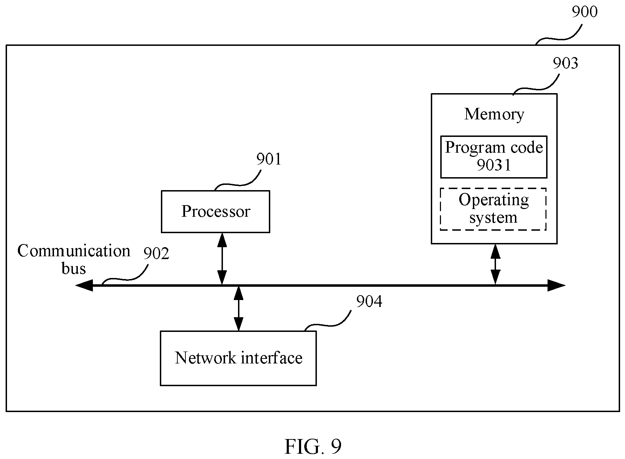

An embodiment of this application provides a communication device. The device includes a processor and a memory. The memory stores at least one computer instruction, and the computer instruction is loaded and executed by the processor to implement the foregoing service signal scheduling method. For example, FIG. 9 is a schematic structural diagram of the device. The device 900 includes at least one processor 901, a communication bus 902, a memory 903, and at least one network interface 904.

The processor 901 is, for example, a general-purpose central processing unit (central processing unit, CPU), a network processor (network processor, NP), a graphics processing unit (Graphics Processing Unit, GPU), a neural-network processing unit (neural-network processing unit, NPU), a data processing unit (Data Processing Unit, DPU), a microprocessor, or one or more integrated circuits configured to implement the solutions of this application. For example, the processor 901 is an application-specific integrated circuit (application-specific integrated circuit, ASIC), a programmable logic device (programmable logic device, PLD), or a combination thereof. The PLD is, for example, a complex programmable logic device (complex programmable logic device, CPLD), a field-programmable gate array (field-programmable gate array, FPGA), a generic array logic (generic array logic, GAL), or any combination thereof.

The communication bus 902 is configured to transmit information between the foregoing components. The communication bus 902 may be classified into an address bus, a data bus, a control bus, and the like. For ease of indication, the bus is indicated by using only one bold line in FIG. 9. However, it does not indicate that there is only one bus or only one type of bus.

The memory 903 is, for example, a read-only memory (read-only memory, ROM) or another type of static storage device that can store static information and instructions, a random access memory (random access memory, RAM) or another type of dynamic storage device that can store information and instructions, or an electrically erasable programmable read-only memory (electrically erasable programmable read-only Memory, EEPROM), a compact disc read-only memory (compact disc read-only memory, CD-ROM) or another compact disc storage, an optical disc storage (including a compressed optical disc, a laser disc, an optical disc, a digital versatile disc, a Blu-ray disc, or the like), a magnetic disk storage medium or another magnetic storage device, or any other medium that can be for carrying or storing expected program code in a form of instructions or a data structure and that can be accessed by a computer. However, the memory 903 is not limited thereto. For example, the memory 903 may exist independently, and is connected to the processor 901 through the communication bus 902. Alternatively, the memory 903 may be integrated with the processor 901.

Optionally, the memory 903 is configured to store transmitted data and the like.

The network interface 904 is configured to communicate with another device or a communication network by using any transceiver-type apparatus. The network interface 904 includes a wired network interface, and may further include a wireless network interface. The wired network interface may be, for example, an Ethernet interface. The Ethernet interface may be an optical interface, an electrical interface, or a combination thereof. The wireless network interface may be a wireless local area network (wireless local area network, WLAN) interface, a cellular network interface, or a combination thereof.

In specific implementation, in an example, the processor 901 may include one or more CPUs.

In specific implementation, in an example, the device 900 may include a plurality of processors. Each of the processors may be a single-core processor (single-CPU) or may be a multicore processor (multi-CPU). The processor herein may refer to one or more devices, circuits, and/or processing cores configured to process data (for example, computer program instructions).

In some embodiments, the memory 903 is configured to store program code 9031 for scheduling a service signal in this application, and the processor 901 executes the program code 9031 stored in the memory 903. In other words, the device 900 may implement the service signal scheduling method provided in the method embodiment by using the processor 901 and the program code 9031 in the memory 903.

The foregoing description is merely an embodiment of this application, but is not intended to limit this application. Any modification, equivalent replacement, or improvement made without departing from the principle of this application shall fall within the protection scope of this application.

## Claims

1. A communication device, wherein the communication device comprises a cabinet (1), a plurality of subracks (2), and a plurality of switch boards (3), wherein
each subrack (2) comprises a backplane (21) and a plurality of service boards (22), the backplane (21) is located in the subrack (2), the plurality of service boards (22) are pluggably installed in the subrack (2), and each service board (22) is electrically connected to the backplane (21); and
each subrack (2) and each switch board (3) are pluggably installed in the cabinet (1), the backplane (21) of each subrack (2) is electrically connected to at least one of the switch boards (3), and each switch board (3) is electrically connected to at least one backplane (21).

2. The communication device according to claim 1, wherein the backplane (21) of each subrack (2) is electrically connected to any one of the switch boards (3).

3. The communication device according to claim 1 or 2, wherein backplanes (21) of the plurality of subracks (2) are arranged in a first direction, and the plurality of switch boards (3) are arranged in a second direction, wherein the first direction is perpendicular to the second direction.

4. The communication device according to claim 3, wherein the first direction is a direction perpendicular to a cabinet top panel (11) of the cabinet (1), and the second direction is a direction perpendicular to a cabinet side panel (12) of the cabinet (1).

5. The communication device according to claim 4, wherein each backplane (21) is parallel to a cabinet panel (13) of the cabinet (1), and each switch board (3) is parallel to the cabinet side panel (12) of the cabinet (1).

6. The communication device according to any one of claims 1 to 5, wherein bandwidth capacities of a backplane (21) and a service board (22) that are located in a same subrack (2) match each other.

7. The communication device according to any one of claims 1 to 6, wherein each service board (22) is configured to:
determine a destination service board when receiving a service signal;
determine a relationship between the service board and the destination service board; and
determine a destination port and output the service signal through the destination port if the service board and the destination service board belong to a same service board.

8. The communication device according to claim 7, wherein there are a plurality of destination ports, and each service board (22) is configured to:
replicate the service signal based on a quantity of destination ports to obtain a plurality of service signals, and output each service signal through one destination port.

9. The communication device according to any one of claims 1 to 8, wherein any two service boards (22) in each subrack (2) are electrically connected, and each service board (22) is configured to:
determine a destination service board when receiving a service signal;
determine a relationship between the service board and the destination service board; and
send the service signal to the destination service board if the service board and the destination service board belong to different service boards but a same subrack (2).

10. The communication device according to claim 9, wherein there are a plurality of destination service boards, and each service board (22) is configured to:
replicate the service signal based on a quantity of destination service boards to obtain a plurality of service signals, and send the service signal to each destination service board.

11. The communication device according to any one of claims 1 to 10, wherein each service board (22) is configured to:
determine a destination service board when receiving a service signal;
determine a relationship between the service board and the destination service board; and
send the service signal to the switch board (3) if the service board and the destination service board belong to different service boards and different subracks (2), so that the switch board (3) sends the service signal to the destination service board.

12. The communication device according to any one of claims 7 to 11, wherein the destination service board is determined based on the service board that receives the service signal and a pre-stored service board correspondence; and
the destination port is determined based on a port that receives the service signal and a pre-stored port correspondence.

13. The communication device according to any one of claims 7 to 11, wherein both the destination service board and the destination port of the destination service board are determined based on a destination address carried in the service signal.

14. A service signal scheduling method, wherein the method is applied to a communication device, and the method comprises:
determining a destination service board when receiving a service signal;
determining a relationship between a service board that receives the service signal and the destination service board; and
outputting the service signal based on the relationship between the service board that receives the service signal and the destination service board.

15. The method according to claim 14, wherein the determining a relationship between a service board that receives the service signal and the destination service board comprises:
determining that the service board that receives the service signal and the destination service board belong to a same service board; and
the outputting the service signal comprises:
determining a destination port based on the destination service board, and outputting the service signal through the destination port.

16. The method according to claim 14 or 15, wherein the determining a relationship between a service board that receives the service signal and the destination service board comprises:
determining that the service board that receives the service signal and the destination service board belong to different service boards and are electrically connected; and
the outputting the service signal comprises:
sending the service signal to the destination service board through the service board that receives the service signal; and
determining a destination port based on the destination service board, and outputting the service signal through the destination port.

17. The method according to any one of claims 14 to 16, wherein the determining a relationship between a service board that receives the service signal and the destination service board comprises:
determining that the service board that receives the service signal and the destination service board belong to different service boards and are not electrically connected; and
the outputting the service signal comprises:
sending the service signal to a switch board through the service board that receives the service signal;
sending the service signal to the destination service board through the switch board; and
determining a destination port based on the destination service board, and outputting the service signal through the destination port.
